(19) Europäisches Patentamt
European Patent Office
Office européen des brevets

(11) **EP 0 500 415 B1**

# (12) FASCICULE DE BREVET EUROPEEN

(45) Date de publication et mention
de la délivrance du brevet:
**08.05.1996 Bulletin 1996/19**

(51) Int Cl.6: **H01R 13/03**, H01B 1/12

(21) Numéro de dépôt: **92400338.7**

(22) Date de dépôt: **10.02.1992**

(54) **Contact de connecteur électrique protégé par un film de polymère et son procédé de fabrication**

Kontakt eines elektrischen Verbinders, geschützt von einem Polymerfilm, und Verfahren zu seiner Herstellung

Contact of an electric connector protected by a polymer film and method for its fabrication

(84) Etats contractants désignés:
**BE DE ES GB IT NL SE**

(30) Priorité: **12.02.1991 FR 9101604**

(43) Date de publication de la demande:
**26.08.1992 Bulletin 1992/35**

(73) Titulaires:
- **COMMISSARIAT A L'ENERGIE ATOMIQUE**
  **F-75015 Paris (FR)**
- **SOURIAU ET CIE**
  **F-78035 Versailles (FR)**

(72) Inventeurs:
- **Boissel, Jacques**
  **F-95290 L'Isle-Adam (FR)**
- **Delhalle, Joseph**
  **B-5380 Noville Les Bois (BE)**

- **Lecayon, Gérard**
  **F-91940 Les Ulis (FR)**
- **Viel, Pascal**
  **F-92190 Meudon (FR)**

(74) Mandataire: **Des Termes, Monique et al**
**Société Brevatome**
**25, rue de Ponthieu**
**F-75008 Paris (FR)**

(56) Documents cités:
EP-A- 0 038 244    EP-A- 0 041 381
EP-A- 0 053 669    EP-A- 0 310 668
DE-A- 3 834 526

- **ETZ ELEKTROTECHNISCHE ZEITSCHRIFT vol. 111, no. 11, juin 1990, pages 554-556, Berlin, DE; K. GIESE: "Intrinsisch elektrisch leitende polymere Flächenstoffe"**

## Description

La présente invention concerne un contact pour connecteur électrique utilisable dans de nombreux domaines tels que l'informatique, l'aéronautique, les télécommunications et les dispositifs implantés dans le corps humain.

De façon plus précise, elle concerne la protection contre la corrosion des contacts de tels connecteurs. Généralement, les contacts des connecteurs électriques sont réalisés en métaux précieux tels que l'or qui possède les qualités requises pour obtenir une faible résistance électrique de contact, un bon frottement et une bonne tenue à la corrosion.

Ainsi, le document EP-A-0310668 décrit un contact électrique comprenant un métal de base tel que du nickel, revêtu d'un film de céramique électriquement conductrice, par exemple du carbure de titane, avec une couche de revêtement intermédiaire électriquement conducteur par exemple en or, disposé entre le métal de base et la céramique.

Cet or est généralement déposé sur une sous-couche de nickel qui joue le rôle de barrière de diffusion. Cependant le coût de l'or grève lourdement les prix de revient.

Des recherches ont donc été entreprises pour remplacer l'or par d'autres matériaux, et on utilise parfois des alliages d'étain et de plomb, ou des alliages de palladium et de nickel.

Cependant, aucune de ces solutions ne donne complète satisfaction.

La présente invention a précisément pour objet un connecteur électrique utilisant pour remplacer l'or sur les contacts, un matériau original.

Selon l'invention, le matériau utilisé est un polymère organique très mince qui normalement est isolant électrique mais qui, conformément à l'invention, a été modifié par un traitement approprié pour lui conférer une conductivité électrique suffisante permettant de maintenir à la valeur voulue la résistance de contact.

Selon l'invention, le contact électrique obtenu possède une résistance de contact d'au plus 10 ohms et il comporte, un métal de base revêtu d'un film de polymère organique électroconducteur, homogène et adhérent, ayant une épaisseur de 5 à 500 nanomètres.

De préférence, la résistance de contact est de 5 à 20 milliohms.

De préférence, on intercale entre le métal de base du contact et le film de polymère une sous-couche de métal ayant une épaisseur de 2 à 10 micromètres, les métaux utilisables étant par exemple le palladium, le fer, le cobalt et de préférence le nickel.

Les corps des contacts du connecteur sont généralement réalisés en un métal de base cuivreux par exemple en cuivre, en alliage de cuivre contenant au moins 50% de cuivre, tel que le laiton, le bronze, le cupronickel et le cuivre faiblement allié.

Cette base, par exemple en métal cuivreux, peut être revêtue tout d'abord d'une sous-couche de nickel, de préférence ductile, sur laquelle est déposé un film de polymère organique très mince (5 à 500 nanomètres d'épaisseur) formé à partir d'un polymère isolant électrique que l'on rend suffisamment conducteur par un traitement approprié.

Les polymères organiques utilisables sont obtenus à partir de polymères normalement isolants qui sont transformés en polymères à structure cyclique et/ou insaturée par traitement thermique ou par irradiation.

Ces polymères sont donc différents des polymères intrinsèquement conducteurs tels que le polyacétylène, le polypyrrole et le polyphénylène qui peuvent être déposés sous forme de films minces à partir de dispersions, comme il est décrit dans DE-A-3834526.

A titre d'exemple de tels polymères isolants, on peut citer le polyacrylonitrile, la polyvinylpyrridine et le polypentafluorostyrène.

Les contacts pour connecteurs électriques de l'invention sont ainsi très avantageux car ils permettent d'éviter l'emploi de revêtements d'or coûteux en les remplaçant par des films ultra-minces de polymères organiques qui assurent la protection voulue en résistant de plus au frottement des surfaces de contact.

L'invention a également pour objet un procédé pour protéger contre la corrosion la surface d'un contact pour connecteur électrique qui comprend les étapes successives suivantes :

a) déposer sur cette surface un film mince de polymère organique isolant, ayant une épaisseur de 5 à 500 nanomètres, par électropolymérisation sous polarisation cathodique, et
b) soumettre ce film de polymère à un traitement thermique ou à une irradiation pour lui conférer une conductivité électrique telle que la résistance de contact du connecteur électrique n'excède pas 10 ohms.

De préférence, ce procédé comprend une étape préalable de dépôt d'une sous-couche métallique de 2 à 10 micromètres d'épaisseur, par exemple de nickel, sur la surface du contact.

Avantageusement, on dépose cette couche par voie électrochimique car ce mode de dépôt donne une sous-couche présentant de bonnes propriétés, notamment dans le cas du nickel. De plus, les procédés de dépôt électrolytique sont des procédés classiques largement utilisés à l'échelle industrielle.

Dans la première étape du procédé de l'invention, on dépose donc soit directement sur la surface du contact, soit sur une sous-couche métallique intermédiaire, un film mince du polymère organique par électropolymérisation sous polarisation cathodique, en utilisant le contact comme cathode. Généralement, on utilise une solution du monomère, par exemple l'acrylonitrile, dans un solvant organique approprié qui ne dissout pas le polymère formé et contient un électrolyte-support, par exemple un perchlorate de tétraalkyl ammonium. La concentration en monomère peut varier dans une large gamme, par exemple de $10^{-1}$ mol/l à 10 mol/l ; dans certains cas, on peut même supprimer le solvant organique et utiliser le monomère pur comme solvant de l'électrolyte-support. La concentration en électrolyte-support peut également varier dans une large gamme en restant inférieure à celle du monomère. Pour effectuer l'électropolymérisation, on applique à la cathode un potentiel approprié qui dépend en particulier du monomère à électropolymériser. Dans le cas de l'acrylonitrile sur nickel, ce potentiel doit être plus négatif que ou égal à -2,4 V/Ag-Ag$^+$. Un procédé d'électropolymérisation utilisable dans l'invention est décrit en particulier dans le document EP-A-0 038 244. Dans cette deuxième étape, le polymère déposé peut être en particulier le polyacrylonitrile, la polyvinylpyrridine ou le polypentafluorostyrène.

Dans la deuxième étape b) du procédé, on soumet le film de polymère déposé par électropolymérisation à un traitement approprié permettant d'augmenter sa conductivité électrique sans détériorer ses propriétés de protection contre la corrosion et de résistance au frottement.

Ce traitement peut consister en un traitement thermique ou en une irradiation qui permet de modifier le film de polymère mince déposé pour le transformer en un dérivé à structure cyclisée ou insaturée.

Le traitement thermique peut être effectué par exemple à une température de 200 à 300°C.

Le traitement d'irradiation peut être effectué au moyen d'un rayonnement ultraviolet, ou encore au moyen du faisceau blanc du rayonnement synchrotron.

Dans le cas des traitements thermiques, on choisit la température et la durée du traitement en fonction du polymère traité pour obtenir la conductivité électrique voulue.

Dans le cas des traitements d'irradiation sous rayonnement ultra-violet, ceux-ci peuvent être effectués sous air ou sous atmosphère inerte, par exemple sous argon, et l'on choisit les conditions de traitement telles que la durée et l'atmosphère d'irradiation, en fonction du polymère traité pour obtenir la conductivité voulue.

Dans le cas des traitements d'irradiation par le rayonnement blanc synchrotron, on choisit également la durée du traitement en fonction du polymère utilisé pour obtenir le résultat voulu.

On rappelle que le faisceau blanc du rayonnement synchrotron est le faisceau issu d'un synchrotron avant monochromatisation ; celui-ci comprend un rayonnement analogue au visible enrichi en ultra-violets et en rayons X mous dont les longueurs d'onde vont de 2 à quelques milliers d'Angströms.

D autres caractéristiques et avantages de l'invention apparaîtront mieux à la lecture de la description qui suit d'exemples de réalisation de l'invention, donnés bien entendu à titre illustratif et non limitatif en référence aux dessins annexés sur lesquels :

la figure 1 représente schématiquement un connecteur électronique,

- les figures 2 et 3 sont les spectres infrarouge de films de polyacrylonitrile traités à une température de 200°C sous air, pendant 2 heures (figure 2) et pendant 24 heures (figure 3) ;
- la figure 4 illustre la méthode de mesure du coefficient de frottement du film de l'exemple 2 ;
- les figures 5 à 8 sont les spectres infrarouge de films de polyacrylonitrile soumis à une irradiation au moyen de rayonnements ultraviolets pendant des durées de 2 minutes (figure 5), 4 minutes (figure 6), 8 minutes (figure 7) et 16 minutes (figure 8) ;
- les figures 9 à 11 sont les spectres infrarouge de films de polyacrylonitrile irradiés au moyen de rayonnements ultraviolets sous argon pendant une durée de 2 minutes (figure 9), 8 minutes (figure 10) et 16 minutes (figure 11) ;
- la figure 12 est un spectre infrarouge illustrant l'évolution de la structure d'un film de polyacrylonitrile qui a été traité par irradiation ultraviolette pendant 2 minutes, puis maintenu dans une atmosphère de brouillard salin à 35°C pendant 221 heures ;
- la figure 13 est le spectre infrarouge d'un film de polyacrylonitrile qui n'a pas subi de traitement d'irradiation par rayonnement ultraviolet, mais a été exposé pendant 221 heures à 35°C dans un brouillard salin comme dans le cas de la figure 12 ;
- la figure 14 est le spectre infrarouge d'un film de polyacrylonitrile qui a été irradié au moyen de rayonnement ultraviolet pendant 2 minutes, après séjour pendant 28 jours à 40°C dans une atmosphère humide à 93 % d'humidité ; et
- la figure 15 est le spectre infrarouge d'un film de polyacrylonitrile qui n'a subi aucun traitement d'irradiation, après séjour à 40°C pendant 28 jours dans une atmosphère à 93 % d'humidité comme dans le cas du film de la figure 14.

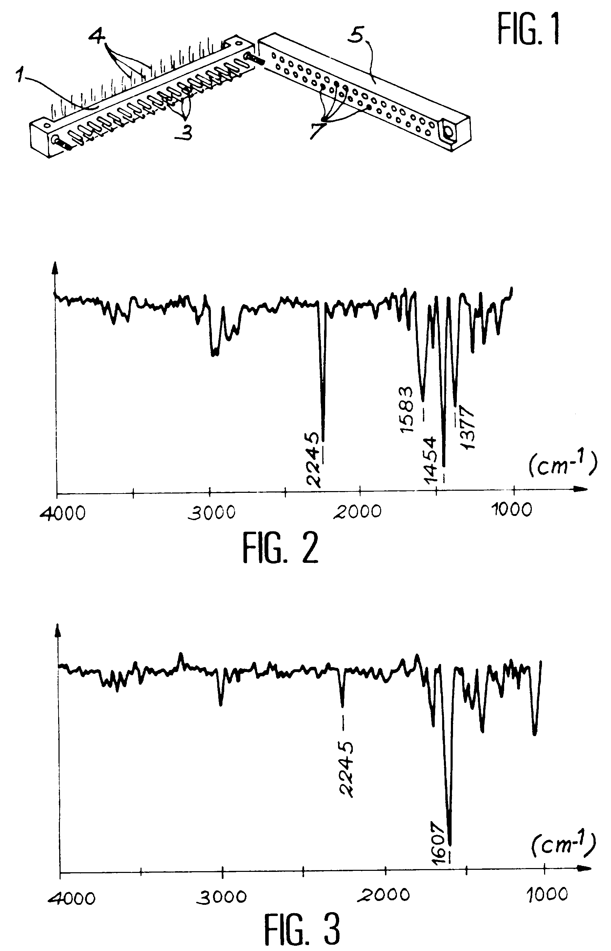

Sur la figure 1, on a représenté schématiquement un connecteur électronique dans lequel l'élément mâle 1 est muni de plusieurs contacts 3 en métal de base, par exemple en cuivre, et de picots de raccordement 4. Ce connecteur comporte un élément femelle 5 muni également de plusieurs contacts 7 également en métal de base, par exemple en cuivre.

Conformément à l'invention, les surfaces des contacts 3 et/ou les surfaces des contacts 7 sont protégées par un film de polymère qui permet d'obtenir une résistance de contact d'au plus 10ohms.

Exemple 1

Cet exemple illustre l'utilisation d'une couche de protection comportant une sous-couche de nickel et un film de polyacrylonitrile soumis à un traitement thermique.

Dans cet exemple la surface de contact à revêtir est une surface de laiton sur laquelle on dépose tout d'abord par électrolyse une sous-couche de nickel de 2μm d'épaisseur. On forme ensuite par électropolymérisation sur la sous-couche de nickel un film de polyacrylonitrile ayant une épaisseur de 30 nm.

Pour le dépôt du film, on utilise comme solution d'électrolyse une solution d'acétonitrile contenant :

2,5 mole par litre d'acrylonitrile,

- $5.10^{-2}$ mole par litre de perchlorate de tétraéthyl ammonium, et
- moins de $5.10^{-4}$ mole par litre d'eau.

Pour effectuer le dépôt du film, on maintient la cathode a un potentiel d'environ -2,4 Volts par rapport à une électrode Ag/Ag$^+$, pendant 2 secondes.

On obtient ainsi un film de polyacrylonitrile de 30 nanomètres d'épaisseur, et on soumet celui-ci à un traitement thermique effectué à une température de 200°C à l'air pendant 2 heures.

Sur la figure 2 on a représenté le spectre infrarouge du film obtenu après ce traitement.

Sur cette figure, on remarque la naissance et/ou la croissance de pics vers 1670 cm$^{-1}$, 1377 cm$^{-1}$ et autour de 1600 cm$^{-1}$.

Exemple 2

Cet exemple illustre également un connecteur électronique en laiton protégé par un film de polyacrylonitrile traité thermiquement.

Dans cet exemple on suit le même mode opératoire que dans l'exemple 1 pour protéger la surface de contact par une sous-couche de nickel et un film de polyacrylonitrile mais on effectue le traitement thermique à 200°C sous air pendant 24 heures.

Le spectre infrarouge du film obtenu après ce traitement est représenté sur la figure 3.

Sur cette figure on voit que la bande de vibration des CH$_2$ à 1454 cm$^{-1}$ et la bande nitrile à 2245 cm$^{-1}$ ont fortement diminué. L'absorption principale se situe maintenant vers 1600 cm$^{-1}$ et on note également une forte absorption à 1700 cm$^{-1}$.

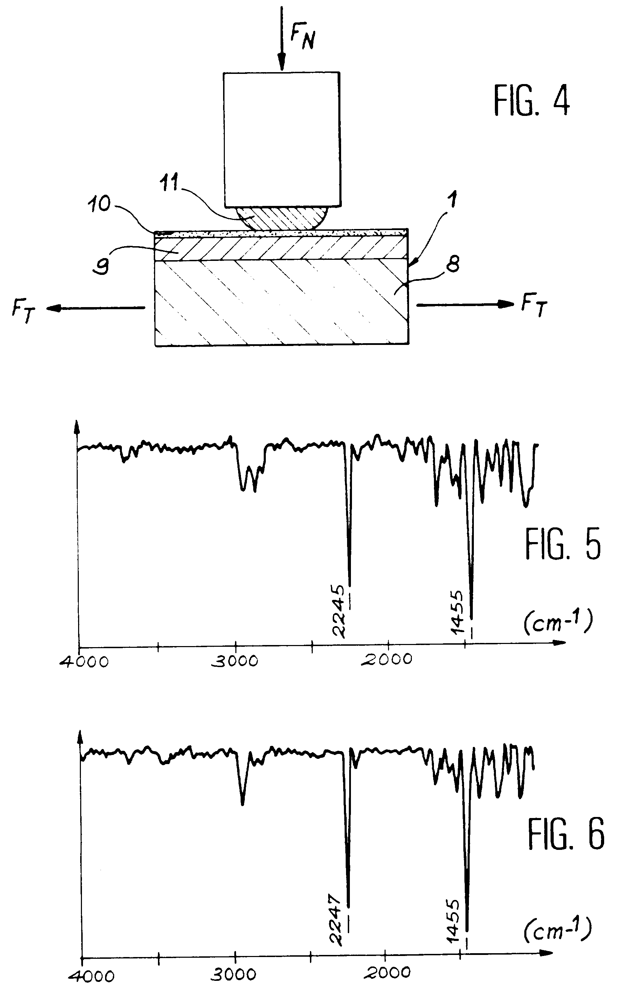

On vérifie les propriétés du film ainsi traité en déterminant son coefficient de frottement, sa structure par imagerie Auger et son comportement isolant. Le coefficient de frottement est déterminé en utilisant la méthode sphère-plan illustrée sur la figure 4.

Sur cette figure, la surface de contact électrique 8 revêtue de la sous-couche de nickel 9 et du film de polymère 10 est disposée sous une bille 11 sphérique dorée rugueuse de 2,8 mm de diamètre, appliquée sur la surface de contact avec une force d'appui F$_N$ de 0,8N. Le coefficient de frottement $\bar{\mu}$ est défini par la formule

$$\bar{\mu} = F_T/F_N$$

dans laquelle F$_T$ est la force tangentielle nécessaire pour déplacer la surface de contact de 1 mm à une vitesse de 0,1 mm/s lorsqu'on applique la force d'appui F$_N$.

Le coefficient de frottement est de 0,14 et il reste faible et constant après 40 cycles.

Par imagerie Auger, on remarque des traces de dégradation sur le film mais il reste quand même du polymère.

La résistance de contact du connecteur est de quelques ohms sous une force de 80 gF (soit environ 150 MPa), et elle n'est plus que de 14 milliohms sous une force de 120 gF (soit environ 200 MPa). Ainsi le film traité n'a plus le comportement d'un isolant électrique.

Exemple 3

Cet exemple illustre la réalisation d'une protection en polyacrylonitrile modifiée par irradiation au moyen de rayonnement ultraviolet.

On suit le même mode opératoire que dans l'exemple 1 pour revêtir un contact électrique en laiton par une sous-couche de nickel et un film de polyacrylonitrile de 30 nanomètres d'épaisseur. On soumet ensuite le film à un traitement d'irradiation au moyen de rayonnement ultraviolet sous air pendant 2 minutes.

La figure 5 représente le spectre infrarouge du film obtenu après ce traitement.

Exemple 4

Dans cet exemple on suit le même mode opératoire que dans l'exemple 3 mais on effectue l'irradiation pendant 4 minutes.

La figure 6 représente le spectre infrarouge du film obtenu dans ces conditions.

Exemple 5

On suit le même mode opératoire que dans l'exemple 3 mais on réalise l'irradiation pendant 8 minutes

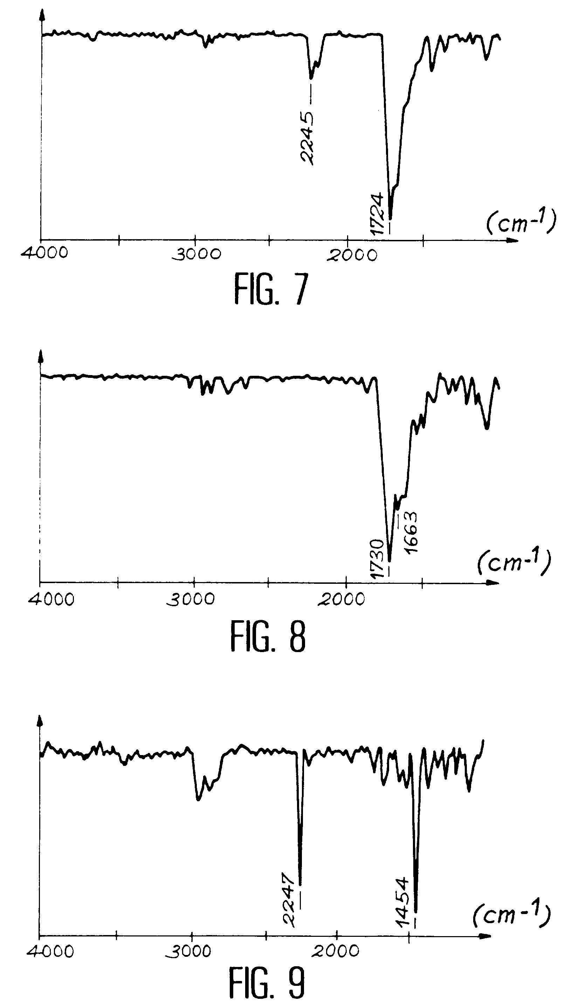

La figure 7 représente le spectre infrarouge du film de polyacrylonitrile traité dans ces conditions.

Exemple 6

Dans cet exemple, on suit le même mode opératoire que dans l'exemple 3 mais on réalise l'irradiation pendant 16 minutes.

La figure 8 représente le spectre infrarouge du film traité dans ces conditions.

En comparant les spectres des figures 5 à 8, on remarque que la bande nitrile à 2245 $cm^{-1}$ se réduit brutalement entre 4 et 8 minutes de traitement et qu'elle disparaît complètement au bout de 16 minutes. Il en est pratiquement de même pour la bande à 1455 $cm^{-1}$. Après 16 minutes on a essentiellement un doublet à 1690 $cm^{-1}$ et 1740 $cm^{-1}$, ce qui pourrait correspondre à l'apparition de fonctions amide et cétone. On remarque également un affaiblissement des bandes CH de la région 2900 $cm^{-1}$.

Ainsi après le traitement par irradiation UV sous air pendant 8 minutes, l'oxydation du film est exarcerbée. il y a présence d'insaturations et un faible taux de cyclisation.

Les propriétés électriques et mécaniques du film traité par irradiation UV sous air pendant 16 minutes sont les suivantes :

- le coefficient de frottement est de 0,26 et il reste constant après 20 cycles. Cette valeur est moyenne et un peu supérieure à celle obtenue par traitement thermique.
- Le film ne se déchire pas ; la trace de frottement est repérable mais le film résiste mieux que dans le cas des films traités thermiquement.
- Le film n'a pas de comportement isolant ; la résistance de contact Rc étant de quelques ohms sous 80 gF.

Exemple 7

Dans cet exemple on suit le même mode opératoire que dans l'exemple 1 pour revêtir un contact électrique en laiton d'une sous-couche de nickel et d'un film de polyacrylonitrile de 30 nanomètres d'épaisseur, mais on réalise l'électropolymérisation en maintenant la cathode à un potentiel d'environ -2,4V par rapport à une électrode Ag/Ag$^+$ en réalisant 10 séquences de 25ms, et on soumet ensuite le film à une irradiation sous rayonnement ultraviolet sous atmosphère d'argon pendant 2 minutes.

La figure 9 représente le spectre infrarouge du film traité dans ces conditions.

Exemple 8

On suit le même mode opératoire que dans l'exemple 7 mais on réalise l'irradiation pendant 8 minutes.

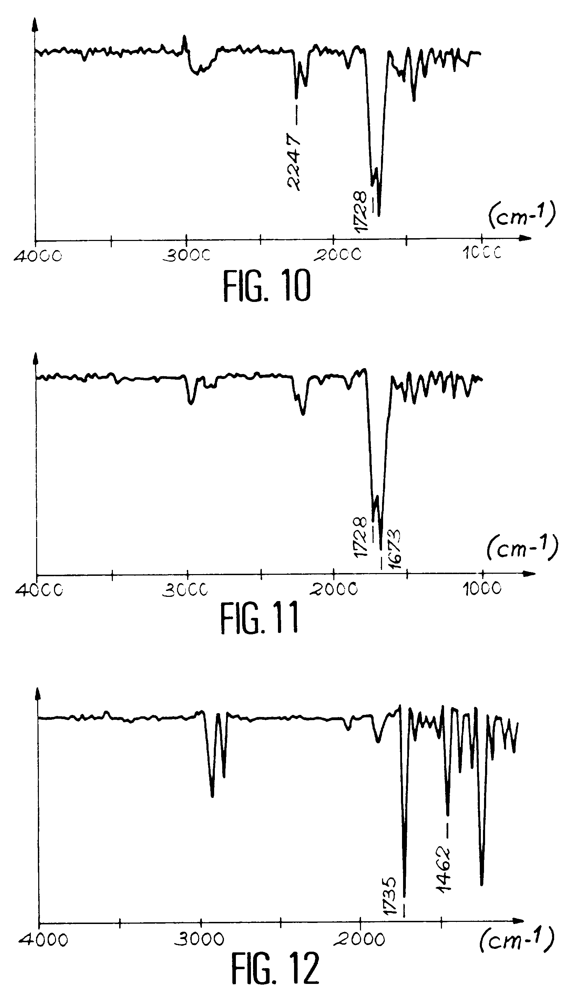

La figure 10 représente le spectre infrarouge du film traité dans ces conditions.

Exemple 9

On suit le même mode opératoire que dans l'exemple 7 mais on réalise l'irradiation pendant 16 minutes.

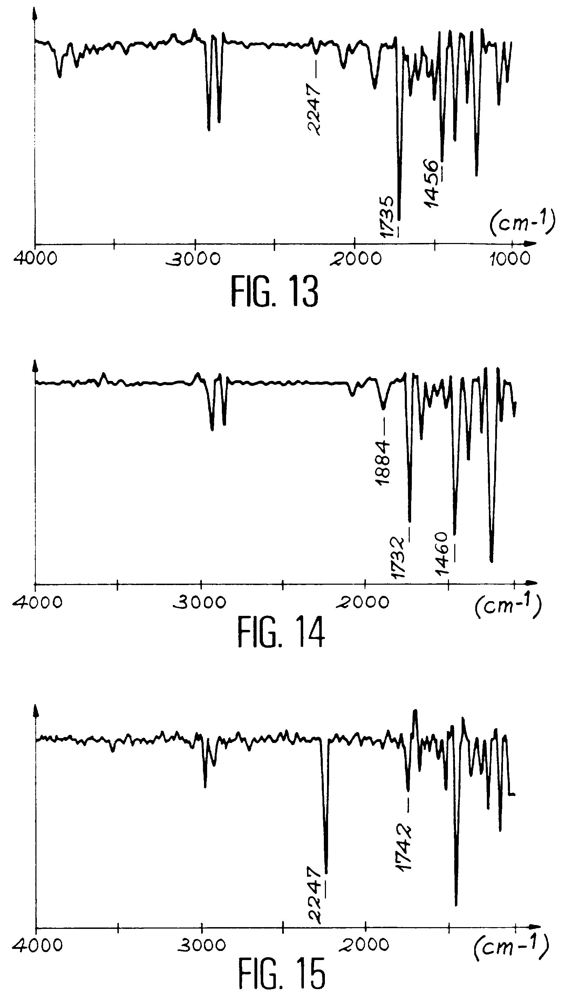

La figure 11 représente le spectre infrarouge du film traité dans ces conditions.

Si l'on compare les figures 9 à 11, on remarque que la bande nitrile à 2247 $cm^{-1}$ décroît aussi avec la durée du traitement, mais qu'elle ne disparaît pas complètement. L'absorption autour de 2200 $cm^{-1}$ se développe, alors qu'elle disparaissait lorsqu'on réalisait l'irradiation sous air. Les absorptions nouvelles à 1683 $cm^{-1}$ et 1728 $cm^{-1}$ forment un doublet voisin du doublet observé lors de l'irradiation sous air mais avec des intensités relatives inversées, l'absorption à 1728 $cm^{1}$ étant la plus faible alors que sous air elle est la plus forte.

Ainsi, lorsqu'on réalise l'irradiation UV sous argon, les structures correspondant aux degrés d'oxydation supérieurs sont plus faibles qu'en opérant sous air. En revanche, les insaturations et les cyclisations sont plus importantes que sous air.

Dans le tableau annexé, on a indiqué les températures finales des films traités dans les exemples 3 à 9.

Exemple 10

Dans cet exemple on vérifie la tenue à la corrosion de films de polyacrylonitrile traités par irradiation UV pendant 2 minutes sous argon obtenus comme dans l'exemple 7 et on la compare à celle de films de polyacrylonitrile obtenus dans les mêms conditions mais non soumis au traitement d'irradiation.

Dans cet exemple, on expose les contacts revêtus de la sous-couche de nickel et du film de polyacrylonitrile traité ou non traité à une température de 35°C, pendant 221 heures dans du brouillard salin.

Sur la figure 12, on a représenté le spectre infrarouge du film de polyacrylonitrile traité, après cette exposition au brouillard.

Sur la figure 13, on a représenté le spectre infrarouge du film de polyacrylonitrile non traité, après cette exposition au brouillard salin.

En comparant ces figures, on remarque que la bande nitrile à 2247 $cm^{-1}$ a complètement disparu sur la figure 12 mais qu'elle est également très faible sur le spectre infrarouge de la figure 13. En revanche, les autres bandes d'absorption sont pratiquement identiques pour les deux spectres. Ainsi, le traitement d'irradiation UV n'a pratiquement pas modifié le pouvoir protecteur du film de polyacrylonitrile. Par ailleurs, on n'observe aucune corrosion de la sous-couche de nickel.

Exemple 11

Dans cet exemple on teste les propriétés de protection en chaleur humide de films de polyacrylonitrile traités ou non traités obtenus de la même façon que ceux utilisés dans l'exemple 10.

Dans cet exemple, on place les films traités, pendant 28 jours dans une étuve à 40°C et 93 % d'humidité relative, c'est-à-dire proche de la saturation et les films non traités pendant 17 jours dans une étuve à 70°C et 80 % d'humidité relative.

Sur la figure 14, on a représenté le spectre infrarouge du film traité, après ce séjour en étuve.

Sur la figure 15, on a représenté le spectre infrarouge du film de polyacrylonitrile non traité, après le séjour en étuve à 70°C.

En comparant les figures 14 et 15, on remarque que le pic nitrile à 2247 $cm^{-1}$ a complètement disparu dans le film traité et qu'il y a développement de structure carbonyle (1732 $cm^{-1}$), cyclisées (1663 $cm^{-1}$) et amines tertiaires (1245 $cm^{-1}$) dans le film traité.

Cependant, il ne se produit aucune corrosion du nickel de base.

Tableau

| Exemples | Irradiation UV | Température finale | Observations |
|---|---|---|---|
| Ex. 3 | 2min/Air | 58°C | 1/2 régime Point focal |
| Ex. 4 | 4min/Air | 85°C | |
| Ex. 5 | 8min/Air | 104°C | |
| Ex. 6 | 16min/Air | 130°C | |
| Ex. 7 | 2min/Argon | 55°C | 1/2 régime Point focal |
| Ex. 8 | 8min/Argon | 70°C | |
| Ex. 9 | 16min/Argon | 70°C | |

**Revendications**

1. Contact pour connecteur électrique possédant une résistance de contact d'au plus 10 ohms, comportant un métal de base revêtu d'un film de polymère organique électroconducteur, homogène et adhérent, ayant une épaisseur de 5 à 500 nanomètres,

2. Contact selon la revendication 1, caractérisé en ce qu'il comprend une sous-couche de métal ayant une épaisseur de 2 à 10 micromètres entre le métal de base et le film de polymère.

3. Contact selon l'une quelconque des revendications 1 et 2, caractérisé en ce que sa résistance de contact est de 5 à 20 milliohms.

4. Contact selon l'une quelconque des revendications 1 à 3, caractérisé en ce que le métal de base est du cuivre ou un alliage de cuivre contenant au moins 50 % de cuivre.

5. Contact selon la revendication 2, caractérisé en ce que la sous-couche est en nickel.

6. Contact selon l'une quelconque des revendications 1 et 2, caractérisé en ce que le film de polymère est constitué d'un dérivé de polymère à structure cyclisée et/ou insaturée.

7. Contact selon la revendication 6, caractérisé en ce que le dérivé de polymère à structure cyclisée et/ou insaturée est un dérivé de polyacrylonitrile.

8. Contact selon la revendication 6, caractérisé en ce que le dérivé de polymère à structure cyclisée et/ou insaturée est un dérivé de la polyvinylpyrridine ou du polypentafluorostyrène.

9. Connecteur électrique équipé de contacts selon l'une quelconque des revendications 1 à 8.

10. Procédé pour protéger contre la corrosion la surface d'un contact pour connecteur électrique, caractérisé en ce qu'il comprend les étapes successives suivantes :

   a) déposer sur cette surface un film mince de polymère organique isolant, ayant une épaisseur de 5 à 500 nanomètres, par électropolymérisation sous polarisation cathodique, et
   b) soumettre le film de polymère à un traitement thermique ou à une irradiation pour lui conférer une conductivité électrique telle que la résistance de contact du connecteur électrique n'excède pas 10 ohms.

11. Procédé selon la revendication 10, caractérisé en ce qu'il comprend une étape préalable de dépôt d'une sous-couche métallique de 2 à 10 micromètres d'épaisseur sur la surface de contact.

12. Procédé selon la revendication 11, caractérisé en ce que la sous-couche métallique est une sous-couche de nickel et en ce qu'on la dépose par voie électrochimique.

13. Procédé selon l'une quelconque des revendications 10 à 12, caractérisé en ce que, dans l'étape b), en réalise un traitement thermique à une température de 200 à 300°C.

14. Procédé selon l'une quelconque des revendications 10 à 12, caractérisé en ce que, dans l'étape b), on réalise une irradiation au moyen d'un rayonnement ultraviolet.

15. Procédé selon l'une quelconque des revendications 10 à 12, caractérisé en ce que, dans l'étape b), on réalise une irradiation au moyen du faisceau blanc du rayonnement synchrotron.

16. Procédé selon l'une quelconque des revendications 10 à 15, caractérisé en ce que le polymère est le polyacrylonitrile.

**Patentansprüche**

1. Kontakt eines elektrischen Verbinders mit einem Kontaktwiderstand von höchstens 10 Ohm, umfassend ein Basismetall, überzogen mit einem homogenen und haftenden Film aus organischem, elektrisch leitendem Polymer mit einer Dicke von 5 bis 500 nm,

2. Kontakt nach Anspruch 1, dadurch gekennzeichnet, daß er eine Metall-Unterschicht mit einer Dicke von 2 bis 10 µm zwischen dem Basismetall und dem Polymerfilm umfaßt.

3. Kontakt nach einem der Ansprüche 1 und 2, dadurch gekennzeichnet, daß sein Kontaktwiderstand 5 bis 20 Milliohm beträgt.

4. Kontakt nach einem der Ansprüche 1 bis 3, dadurch gekennzeichnet, daß das Basismetall Kupfer oder eine Kupferlegierung ist, die wenigstens 50% Kupfer enthält.

5. Kontakt nach Anspruch 2, dadurch gekennzeichnet, daß die Unterschicht aus Nickel ist.

6. Kontakt nach einem der Ansprüche 1 und 2, dadurch gekennzeichnet, daß der Polymerfilm gebildet wird durch ein Polymerisationsderivat mit zyklisierter und/oder ungesättigter Struktur.

7. Kontakt nach Anspruch 6, dadurch gekennzeichnet, daß das Polymerisationsderivat mit zyklisierter und/oder ungesättigter Struktur ein Polyacrylnitril-Derivat ist.

8. Kontakt nach Anspruch 6, dadurch gekennzeichnet, daß das Polymerisationsderivat mit zyklisierter und/oder ungesättigter Struktur ein Derivat des Polyvinylpyridins oder des Polypentafluorstyrols ist.

9. Elektrischer Steckverbinder, ausgestattet mit Kontakten nach einem der Ansprüche 1 bis 8.

10. Verfahren um die Oberfläche eines Kontakts eines elektrischen Verbinders gegen Korrosion zu schützen, **dadurch gekennzeichnet,** daß es folgende Schritt umfaßt:

   a) Aufbringen eines dünnen Films einer Dicke von 5 bis 500 nm aus organischem isolierendem Polymer auf dieser Oberfläche mittels Elektropolymerisation unter Kathodenpolarisierung, und
   b) Durchführen einer Wärmebehandlung oder einer Bestrahlung des Films, um ihm eine solche elektrische Leitfähigkeit zu verleihen, daß der Kontaktwiderstand des elektrischen Verbinders 10 Ohm nicht überschreitet.

11. Verfahren nach Anspruch 10, dadurch gekennzeichnet, daß es einen vorangehenden Abscheidungsschritt einer metallischen Unterschicht von 2 bis 10μm Dicke auf der Kontaktoberfläche umfaßt.

12. Verfahren nach Anspruch 11, dadurch gekennzeichnet, daß die metallische Unterschicht eine Nickel-Unterschicht ist und daß man sie auf elektrochemischem Wege abscheidet.

13. Verfahren nach einem der Ansprüche 10 bis 12, dadurch gekennzeichnet, daß man in dem Schritt b) eine Wärmebehandlung mit einer Temperatur von 200 bis 300°C durchführt.

14. Verfahren nach einem der Ansprüche 10 bis 12, dadurch gekennzeichnet, daß man in dem Schritt b) eine Strahlenbehandlung mittels einer ultravioletten Bestrahlung durchführt.

15. Verfahren nach einem der Ansprüche 10 bis 12, dadurch gekennzeichnet, daß man in dem Schritt b) eine Strahlenbehandlung mittels des weißen Bündels bzw. Strahls der Synchrotron-Strahlung durchführt.

16. Verfahren nach einem der Ansprüche 10 bis 15, dadurch gekennzeichnet, daß das Polymer das Polyacrylnitril ist.

**Claims**

1. Contact for electrical connector having a contact resistance of at the most 10 ohms, incorporating a base metal covered with a 5 to 500 nanometre thick, homogeneous, adhesive electroconductive, organic polymer film.

2. Contact according to claim 1, characterized in that it comprises a metal underlayer with a thickness of 2 to 10 micrometres between the base metal and the polymer film.

3. Contact according to either of the claims 1 and 2, characterized in that its contact resistance is 5 to 20 milliohms.

4. Contact according to any one of the claims 1 to 3, characterized in that the base metal is copper or a copper alloy containing at least 50% copper.

5. Contact according to claim 2, characterized in that the underlayer is of nickel,

6. Contact according to either of the claims 1 and 2, characterized in that the polymer film is constituted by a polymer derivative having a cyclized and/or unsaturated structure.

7. Contact according to claim 6, characterized in that the polymer derivative with the cyclized and/or unsaturated structure is a polyacrylonitrile derivative.

8. Contact according to claim 6, characterized in that the polymer derivative with a cyclized and/or unsaturated structure is a derivative of polyvinyl pyrridine or polypentafluorostyrene.

9. Electrical connector equipped with contacts according to any one of the claims 1 to 8.

10. Process for protecting against corrosion the surface of a contact for an electrical connector, characterized in that it comprises the following successive stages:

a) the deposition on said surface of a thin, organic, insulating polymer film with a thickness of 5 to 500 nanometres by electropolymerization under cathodic polarization and

b) the subjecting of the polymer film to a heat treatment or an irradiation to give it an electrical conductivity such that the contact resistance of the electrical connector does not exceed 10 ohms.

11. Process according to claim 10, characterized in that it comprises a prior stage of depositing a 2 to 10 micrometre thick metallic underlayer on the contact surface.

12. Process according to claim 11, characterized in that the metallic underlayer is a nickel underlayer and in that it is deposited electrochemically.

13. Process according to any one of the claims 10 to 12, characterized in that, in stage b), a heat treatment is performed at a temperature of 200 to 300°C.

14. Process according to any one of the claims 10 to 12, characterized in that, in stage b), an irradiation is carried out by means of ultraviolet rays.

15. Process according to any one of the claims 10 to 12, characterized in that, in stage b), an irradiation is carried out by means of the white beam of synchrotron radiation.

16. Process according to any one of the claims 10 to 15, characterized in that the polymer is polyacrylonitrile.

FIG. 1

FIG. 2

FIG. 3

10

FIG. 4

FIG. 5

2245

1455

(cm⁻¹)

FIG. 6

2247

1455

(cm⁻¹)

FIG. 7

FIG. 8

FIG. 9

FIG. 10

FIG. 11

FIG. 12

FIG. 13

FIG. 14

FIG. 15